# EUROPEAN PATENT APPLICATION

(11) **EP 1 467 217 A2**
(43) Date of publication of application: **13.10.2004**
(21) Application number: 04007259.7
(22) Date of filing: 25.03.2004
(51) Int. Cl.: G01R 33/09

(54) **Magnetic sensor**

(30) Priority: 31.03.2003 JP 2003096377
(71) Applicant: Denso Corporation, Kariya-city, Aichi-pref., 448-8661 (JP)
(72) Inventor: Ishihara, Masato, Kariya-city Aichi-pref., 448-8661 (JP); Ao, Kenichi, Kariya-city Aichi-pref., 448-8661 (JP)
(74) Representative: Winter, Brandl, Fürniss, Hübner, Röss, Kaiser, Polte Partnerschaft

(57) **Abstract**

A magnetic sensor (10) includes a plurality of magneto-resistive elements (R1 to R8) constituting each magneto-resistive element bridge (11, 12) disposed symmetrically. When the resistance values of the magneto-resistive elements (R1 to R8) patterned are varied in accordance with the angle thereof, the deviation of the center value of the offset voltage of the bridge circuit constructed by the plural magneto-resistive elements can be eliminated.

## Description

### FIELD OF THE INVENTION

The present invention relates to a semiconductor magnetic sensor using a magneto-resistive element.

### BACKGROUND OF THE INVENTION

Amagnetic sensor inwhich right and left magneto-resistive bridges are disposed to be symmetrical to each other for eliminating a magnetic distortion effect caused by an external stress has been disclosed in, for example, JP-A-2001-153683.

Furthermore, a magnetic sensor in which magneto-resistive elements are disposed so that an offset voltage occurring due to misalignment of a magneto-resistive bridge under fabrication or the like can be adjusted has been disclosed in, for example, JP-A-2000-337921.

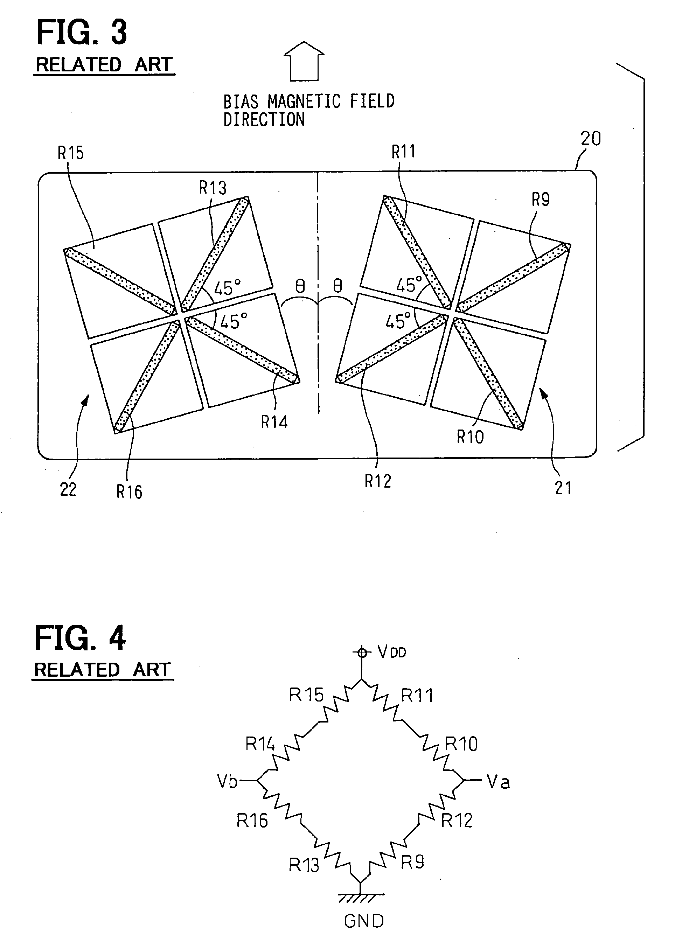

Referring to the block diagram of Fig. 3, a related art magnetic sensor 20 includes magneto-resistive element bridges 21 and 22. Each magneto-resistive element bridge is disposed to be inclined with respect to the direction of a bias magnetic field by an angle of θ. The magneto-resistive bridge 21 comprises four magneto-resistive elements R9 to R12, and the magneto-resistive bridge 22 likewise comprises four magneto-resistive elements R13 to R16.

Fig. 4 is an equivalent circuit of the magnetic sensor 20 shown in Fig. 3. As shown in Fig. 4, the magneto-resistive elements R9 to R16 constitute a bridge circuit.

In the magnetic sensor 20 as described above, variation of the direction of the bias magnetic field caused by rotation of a magnetic body serving as a detection target is detected as variation of the resistance values of the magneto-resistive elements R9 to R16. Specifically, the rotation of the magnetic body as the detection target is detected by using the values of the middle point voltages Va and Vb of the bridge circuit. Accordingly, when there is no variation in the direction of the bias magnetic field, it is desirable that the center value of the offset voltage of the bridge circuit represented by the difference of the middle potentials (Va-Vb) is fixed. Each of the two magneto-resistive element bridges 21 and 22 is inclined by an angle of θ so as to increase the variation of the direction of the magnetic field more significantly.

Each of the magneto-resistive elements R9 to R16 is preferably a ferromagnetic magneto-resistive element mainly formed of Ni (for example, Ni-Co alloy or Ni-Fe alloy). It is formed by attaching thin film onto a glass substrate through vapor deposition or the like and then patterning the result into a predetermined pattern with a glass mask drawing device or the like. The glass mask drawing device reads out an original gage pattern for the magneto-resistive elements formed in advance, and then carries out patterning on the basis of the read data.

However, in the magnetic sensor 20, the line width of the magneto-resistive elements thus patterned may vary erroneously due to a data conversion error in the reading operation of the original gage pattern of the magneto-resistive elements by the glass mask drawing device. The resistance values of the magneto-resistive elements are inversely related to the line width. Therefore, there is a disadvantage that the resistance values are varied when the line width varies, and the center value of the offset voltage corresponding to the difference of the middle-point potentials of the bridge circuit is deviated.

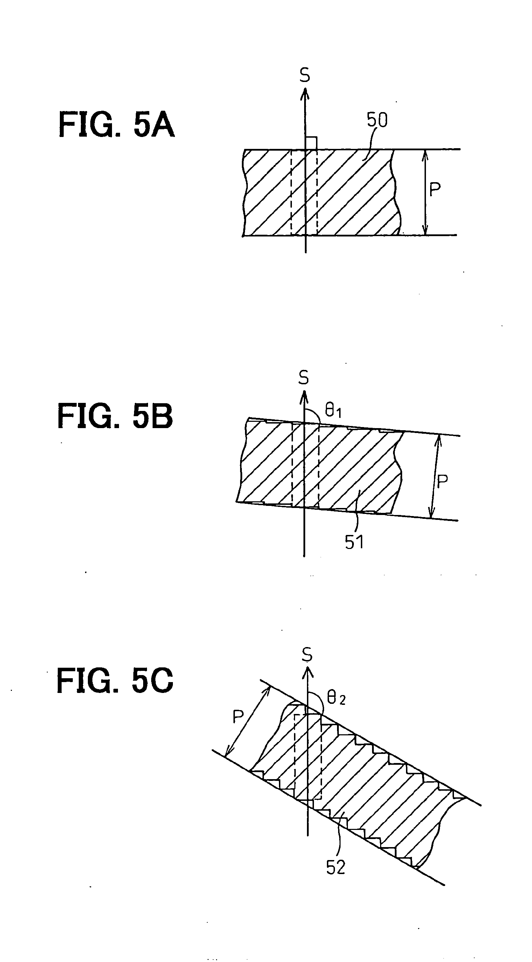

Occurrence of the data conversion error in the reading operation of the original gate pattern will be described with reference to Figs. 5A - 5C. Figs. 5A to 5C show parts of the original gage pattern of a line width P. Fig. 5A shows a case where a part of the original gage pattern is vertical to the scan direction S in the reading operation of the glass mask drawing device, Fig. 5B shows a case where it is inclined with respect to the scan direction S by θ₁, and Fig. 5C shows a case where it is inclined with respect to the scan direction S by θ₂. In the case of Fig. 5A, the original gage pattern of the line width P is recognized as an area 50 having a line width P. However, hatched lines of the original gage pattern having an inclination with respect to the scan direction S are recognized as being stepwise. That is, it is recognized as an area 51 in Fig. 5B and as an area 52 in Fig. 5C. The pattern thus recognized (50, 51, 52) is directly subjected to patterning as the magneto-resistive elements, and thus the resistance values of the magneto-resistive elements to be patterned are varied in accordance with the intersecting angle between the original gage pattern and the scan direction S.

For example, when the resistance value of a magneto-resistiveelementRll is increased in the magnetic sensor 20 of Fig. 3, the resistance values of the magneto-resistive elements R10, R13, R16 having the same inclination as the magneto-resistive element R11 are increased, assuming that the scan direction in the reading operation of the glass mask drawing device is identical to the direction of the bias magnetic field. Accordingly, in the bridge circuit shown in Fig. 4, the voltage of Va falls, and the voltage of Vb rises. Therefore, the center value of the offset voltage corresponding to the difference (Va-Vb)of the middle point potentials of the bridge circuit deviates.

Accordingly, the present invention has an obj ect to provide a magnetic sensor that can prevent the deviation of the center value of the offset voltage of a bridge circuit occurring due to inclination degree of an original gage pattern.

### SUMMARY OF THE INVENTION

A magnetic sensor according to the present invention includes a plurality of magneto-resistive elements constituting each magneto-resistive element bridge disposed to be symmetrical with each other. The magnetic sensor is not limited to including only two symmetrical magneto-resistive element bridges as discussed above. Therefore, when the resistance values of the magneto-resistive elements patterned are varied in accordance with the angle thereof, the deviation of the center value of the offset voltage of the bridge circuit constructed by the plurality of magneto-resistive elements can be eliminated.

The plurality of magneto-resistive elements constituting each magneto-resistive element bridge of the magnetic sensor are preferably disposed radially. Therefore, detection of the magnetic field can be enhanced.

All of the magneto-resistive elements constituting each magneto-resistive element bridge of the magnetic sensor are preferably disposed to have the same fixed angle with respect to the direction of the magnetic field. Therefore, when the resistance values of the magneto-resistive elements patterned are varied in accordance with the angle thereof, they are varied in the same manner, and thus the deviation of the center value of the offset voltage of the bridge circuit which is caused by a data conversion error is eliminated.

Each magneto-resistive bridge of the magnetic sensor is preferably constructed by four magneto-resistive elements disposed radially. Respective two confronting magneto-resistive elements of the four magneto-resistive elements are respectively set as pairs of magneto-resistive elements and disposed linearly. The middle potential of each pair of magneto-resistive elements is set as an output of each magneto-resistive bridge. Therefore, detectionofthemagnetic field can be further enhanced. Also the deviation of the center value of the offset voltage of the bridge circuit caused by the data conversion error can be eliminated.

### BRIEF DESCRIPTION OF THE DRAWINGS

The above and other objects, features and advantages of the present invention will become more apparent from the following detailed description made with reference to the accompanying drawings. In the drawings:
Fig. 1 is a block diagram of a magnetic sensor according to a preferred embodiment;
Fig. 2 is an illustration of an equivalent circuit for the magnetic sensor of Fig. 1;
Fig. 3 is a block diagram of a related art magnetic sensor;
Fig. 4 is an illustration of an equivalent circuit for the magnetic sensor shown in Fig. 3; and
Figs. 5A - 5C are diagrams showing dispersion of a line width which is caused by a data conversion error.

### DETAILED DESCRIPTION OF THE PREFERRED EMBODIMENT

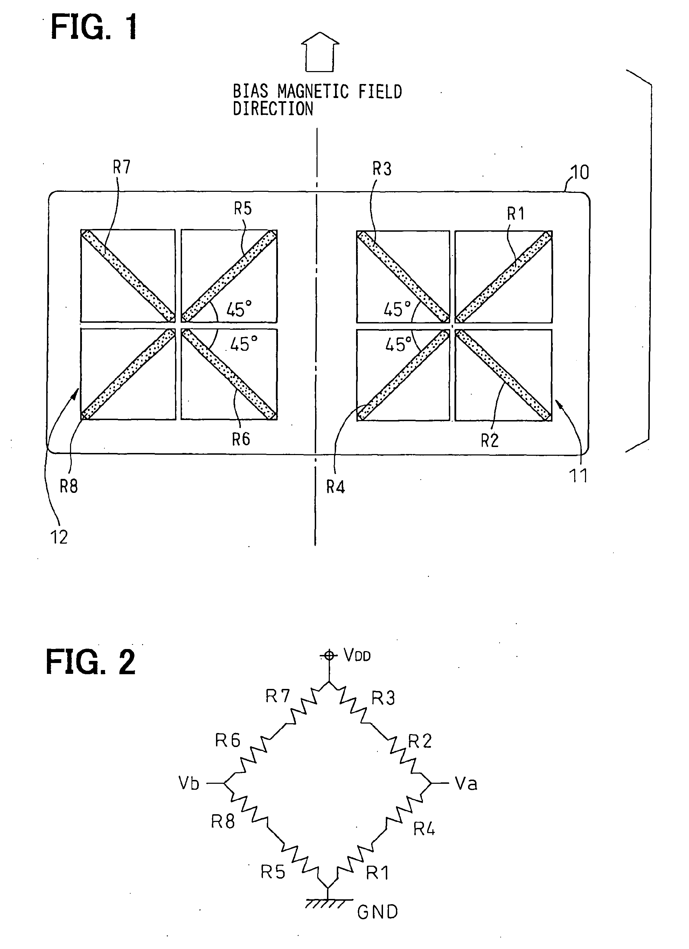

Referring to Figs. 1 - 2, a preferred embodiment of a magnetic sensor 10 will be discussed.

Fig. 1 is a block diagram showing the arrangement of magneto-resistive element bridges of a magnetic sensor 10. The magnetic sensor 10 has two magneto-resistive element bridges 11 and 12. The magneto-resistive element bridges 11 and 12 are disposed to be symmetric to each other with respect to the direction of bias magnetic field. Furthermore, plural magneto-resistive elements constituting each of the magneto-resistive element bridges 11 and 12 are disposed to be symmetric to each other with respect to the direction of the bias magnetic field. The magneto-resistive element bridges 11 and 12 have four magneto-resistive elements R1 to R4 and R5 to R8 which are radially disposed. All the magneto-resistive elements R1 to R8 are disposed to be inclined with respect to the direction of the bias magnetic field by 45 degrees, although they may be reversed with respect to the right-and-left direction. Furthermore, in each of the magneto-resistive element bridges 11 and 12, the respective two confronting magneto-resistive elements are disposed linearly.

Fig. 2 shows an equivalent circuit of the magnetic sensor 10 shown in Fig. 1. As shown in Fig. 2, the magneto-resistive elements R1 to R8 constitute a bridge circuit. In the bridge circuit, the middle point potential between the magneto-resistive elements R1 and R4 and the magneto-resistive elements R2 and R3 of the magneto-resistive element bridge 11 is set as Va, and the middle point potential between the magneto-resistive elements R5 and R8 and the magneto-resistive elements R6 and R7 of the magneto-resistive element bridge 12 is set as Vb.

In the magnetic sensor 10 as described above, the variation of the direction of the bias magnetic field in connection with rotation of a magnetic body serving as a detection target is detected as variation of the resistance values of the magneto-resistive elements R1 to R8 by using the values of the middle point voltages Va and Vb.

Each of the magneto-resistive elements R1 to R8 is formed of a ferromagnetic magneto-resistive element (for example, Ni-Co alloy, Ni-Fe alloy or Mn-Sb alloy). It is formed by attaching thin film onto a glass substrate through vapor deposition or the like and then patterning the result into a predetermined pattern with a glass mask drawing device or the like. The glass mask drawing device reads out an original gage pattern for the magneto-resistive elements which is formed in advance, and then carries out patterning on the basis of the read data.

For example, in the magnetic sensor 10 of Fig. 1, if the resistancevalueofthemagneto-resistiveelementR3 is increased by a data conversion error in the reading operation of the glass mask drawing device, the resistance values of all the other magneto-resistive elements are also increased. This happens because all the other magneto-resistive elements (R1, R2, R4 to R8) have the same inclination as the magneto-resistive element 3, assuming that the scan direction in the reading operation of the glass mask drawing device is identical to the direction of the bias magnetic field. Accordingly, in the bridge circuit shown in Fig. 2, the voltages of Va and Vb do not vary, and there occurs no deviation in the center value of the offset voltage corresponding to the difference (Va-Vb) of the middle point potentials of the bridge circuit.

As described above, not only the two magneto-resistive element bridges are disposed to be symmetric with each other, but also eachmagneto-resistive element bridge itself is designed to be symmetric. Therefore, it is possible to eliminate the deviation of the center value of the offset voltage of the bridge circuit that occurs due to a data conversion error in the reading operation of the glass mask drawing device described above.

The description of the invention is merely exemplary in nature and, thus, variations that do not depart from the gist of the invention are intended to be within the scope of the invention. Such variations are not to be regarded as a departure from the spirit and scope of the invention.

## Claims

1. A magnetic sensor (10) comprising:
a first magneto-resistive bridge (11) constructed by a plurality of magneto-resistive elements (R1, R2, R3, R4) for detecting variation of magnetic field; and
a second magneto-resistive bridge (12) constructed by a plurality of magneto-resistive elements (R5, R6, R7, R8) for detecting variation of the magnetic field, wherein the first magneto-resistive bridge (11) and the second magneto-resistive bridge (12) are disposed to be symmetrical to each other with respect to a direction of the magnetic field, wherein the plurality of magneto-resistive elements (R1, R2, R3, R4) constituting the first magneto-resistive bridge (11) are disposed to be symmetrical with one another with respect to the direction of the electric field, and wherein the plurality of magneto-resistive elements (R5, R6, R7, R8) constituting the second magneto-resistive bridge (12) are disposed to be symmetrical with one another with respect to the direction of the magnetic field.

2. The magnetic sensor according to claim 1, wherein the plurality of magneto-resistive elements of the first or second magneto-resistive bridge are radially disposed.

3. The magnetic sensor according to claim 1, wherein all of the plurality of magneto-resistive elements of the first and second magneto-resistive bridge are disposed to have a fixed angle with respect to the direction of the magnetic field.

4. The magnetic sensor according to claim 1, wherein each of the first and second magneto-resistive bridges (11, 12) comprises four radially disposed magneto-resistive elements, wherein two confronting magneto-resistive elements of the plurality of magneto-resistive elements are respectively set as a pair of magneto-resistive elements, and wherein a middle point potential of each pair of magneto-resistive elements is set as an output of each magneto-resistive bridge.

5. The magnetic sensor according to claim 4, wherein the pair of magneto-resistive elements are disposed linearly.
